# EUROPÄISCHE PATENTSCHRIFT

(11) **EP 1 319 256 B1**
(45) Veröffentlichungstag und Bekanntmachung des Hinweises auf die Patenterteilung: **26.12.2007**
(21) Anmeldenummer: 01971713.1
(22) Anmeldetag: 13.09.2001
(51) Int. Cl.: H01L 31/18, H01L 31/0224

(54) **VERFAHREN ZUR HERSTELLUNG EINER SOLARZELLE UND NACH DIESEM VERFAHREN HERGESTELLTE SOLARZELLE**
METHOD FOR PRODUCING A SOLAR CELL AND A SOLAR CELL PRODUCED ACCORDING TO SAID METHOD
PROCEDE DE FABRICATION D'UNE CELLULE SOLAIRE ET CELLULE SOLAIRE FABRIQUEE SELON LEDIT PROCEDE

(30) Priorität: 22.09.2000 DE 10047556
(43) Veröffentlichungstag der Anmeldung: 18.06.2003
(73) Patentinhaber: Universität Konstanz, 78464 Konstanz (DE)
(72) Erfinder: FATH, Peter, 78464 Konstanz (DE); KRESS, André, 70199 Stuttgart (DE)
(74) Vertreter: RACKETTE Partnerschaft Patentanwälte
(86) Internationale Anmeldenummer: PCT/DE2001/003535
(87) Internationale Veröffentlichungsnummer: WO 2002/025743

(56) Entgegenhaltungen:
- WO-A-99/48136
- US-A- 4 838 952
- US-A- 5 266 125
- GEE J M ET AL: "Emitter wrap-through solar cell" PROCEEDINGS OF THE PHOTOVOLTAIC SPECIALISTS CONFERENCE. LOUISVILLE, MAY 10 - 14, 1993, NEW YORK, IEEE, US, Bd. CONF. 23, 10. Mai 1993 (1993-05-10), Seiten 265-270, XP010113396 ISBN: 0-7803-1220-1 in der Anmeldung erwähnt

## Beschreibung

Die Erfindung betrifft ein Verfahren zur Herstellung von Solarzellen aus kristallinem Silizium.

US-A-4,838,952 offenbart ein Verfahren zur Herstellung von Solarzellen aus kristallinem Silizium, bei dem auf einer Seite eines Siliziumsubstrats vollflächig durch Abscheidung aus der Gasphase eine dielektrische Schicht aufgebracht wird. Mit nachfolgenden Maskierungs- und Ätzschritten werden bis auf die zur späteren Isolierung von Kontakten erforderlichen Bereiche die dielektrische Schicht entfernt. Nachteilig bei dieser Vorgehensweise ist ein verhältnismäßig großer Aufwand, um die letztlich zu maskierenden Bereiche mit der dielektrischen Schicht zu versehen.

Aus WO 99/48136 A ist ein Verfahren zur Herstellung einer Solarzelle aus kristallinem Silizium bekannt, bei der mittels Siebdrucktechnik eine ätzresistente Paste als Ätzschutz auf eine Nitridschicht aufgebracht und nach Durchführen des Ätzschrittes wieder entfernt wird.

Für die elektrische Trennung von p- und n- leitenden Schichten einer Solarzelle genügt nicht nur eine isolierende Trennung, um einen Kurzschluss zu vermeiden. Um den Wirkungsgrad der Solarzelle nicht zu beeinträchtigen darf die Rekombinationsgeschwindigkeit an der Oberfläche dort nicht zu groß sein, wo n- und p-Bereich aneinandergrenzen.

Um diesen Kurzschluss zu verhindern, erfolgt bei konventionellen kristallinen Siliziumsolarzellen die Isolation des pn-Übergangs durch plasmaunterstütztes Ätzen, durch mechanisches Trennen und durch Einsatz von Lasern.

Bei komplexeren Zellgeometrien mit verschachtelten p- und n-leitenden Regionen (wie zum Beispiel EWT- (J.M. Gee, W.K. Schubert, P.A. Basore; "Emitter Wrap-Through Solar Cell"; 23rd IEEE Photo. Spec. Conf., 1993, p. 265-70), POWER-Solarzellen (G. Willeke, P. Fath; "The POWER silicon solar cell concept"; 12th EC PVSEC, Amsterdam, 1994, vol.1, p. 766-68; K. Faika et al., Novel techniques to prevent edge isolation of silicon solar cells by avoiding leakage currents between the aluminum rear contact, Proc. 16th PVSEC, Glasgow, Mai 2000, in Druck; "Recent results in low cost back contact cells", 16th PVSEC, Glasgow, 2000, im Druck) erfolgt die Isolation des pn-Übergangs im Labormaßstab durch:
- plasmaunterstützes Ätzen
- lokales Entfernen des rückseitigen Emitters (z.B. mittels einer Wafersäge oder eines Lasers)
- Verwendung von dielektrischen Schichten als Diffusionsbarriere, kombiniert mit photolithographischen Methoden und Drucktechniken sowie naßchemischen Prozeßschritten.
- Co-Diffusion von aufgedampften Kontakten

Die Nachteile der bekannten Lösungen lassen sich wie folgt zusammenfassen:
- zeit- und kostenintensiv
- teilweise Schädigung der Oberfläche, was zu erhöhter Rekombinationsgeschwindigkeit und damit geringem Wirkungsgrad der Zelle führt.

Zusätzliche Prozeßschritte zur Trennung der p- und n-leitenden Regionen insbesondere bei komplexeren Zellgeometrien sind bei der Produktion im Industriemaßstab von großem Nachteil.
Die daraus resultierenden Kosten waren bisher ein Grund, warum sich z.B. Rückkontaktsolarzellen, trotz ihrer zahlreichen Vorteile bei der Modulverschaltung, in der industriellen Fertigung nicht durchgesetzt haben.

### • physikalische Nachteile

1. Erzeugung offener, d.h. unpassivierter p-n-Übergänge beim mechanischem Randtrennen.
2. durch plasmaunterstütztes Ätzen hervorgerufene Oberflächenschädigungen, die sich aufgrund der damit verbundenen erhöhten Rekombination nachteilig auf die Zellgüte auswirken.
3. durch lokales mechanisches Abfräsen der Rückseite des Siliziumwafers befindet sich die Raumladungszone direkt an der Zelloberfläche. Die durch die Oberfläche eingebrachten Störniveaus sorgen für eine erhöhte Rekombination ("Junction Edge Effects") => Negative Auswirkungen insbesondere auf V_{oc} und FF.

Die der vorliegenden Erfindung zugrunde liegende Aufgabe, nämlich die effiziente Vermeidung der Kurzschlussbildung zwischen aneinandergrenzenden p- und n-leitenden Schichten bei einer Solarzelle wird mit den Merkmalen des Patentanspruches 1 gelöst.

Zumindest auf einer Seite des Siliziumsubstrates wird lokal eine Maskierpaste aufgebracht und anschließend getrocknet. In Folge wird eine Dotierstoffdiffusion durchgeführt, wobei der Leitungstyp des Dotierstoffes entgegengesetzt zu der der Grunddotierung des kristallinen Siliziumsubstrates ist. In einem der folgenden Herstellungsschritte der Solarzelle werden die elektrischen Kontakte so aufgebracht, dass zumindest ein Teil der Kontakte durch die Maskierpaste elektrisch vom Rest der Kontakte getrennt wird.

Dadurch, dass mittels Drucktechnik die Maskierpaste lediglich in den Bereichen aufgebracht wird, die zur Isolierung der Kontakte erforderlich sind, und dass die Maskierpaste auch permanent dort verbleibt, lassen sich die Solarzellen sehr effizient, das heißt in einfacher, eleganter und für die industrielle Fertigung kostengünstigere Art und Weise herstellen.

Zusammenfassend lässt sich sagen, dass das erfindungsgemäße Verfahren eine wesentliche Verbesserung bei der einfachen Herstellung neuartiger Solarzellen wie Rückkontakt-, beidseitig lichtsensitiven und Hochspannungssolarzellen darstellt. Desweiteren wird es wesentliche Impulse bei der Fertigung zukünftiger kostengünstiger Industriesolarzellen unter Verwendung von dünnen Siliziumwafern und der dabei erforderlichen lokalen Rückkontaktierung geben. Fernen kann es zu einer Vereinfachung des gegenwärtigen Herstellungsverfahrens von konventionellen Industriesolarzellen führen.

Die Vorteile der Erfindung stellen sich wie folgt dar:
- Vereinfachte Prozessführung => Kostenersparnis:
- Gute Wirkungsgrade dank geringer Oberflächenrekombinationsgeschwindigkeit

Unter Verwendung der Maskierpaste werden vier Prozessschritte des bisherigen Herstellungsverfahrens
=> ganzflächige Abscheidung eines Dielektrikums
=> Lokales Aufbringen einer Ätzbarriere
=> Prozessschritte zur teilweisen Entfernung des Dielektrikums
=> Entfernen der Ätzbarriere
durch einen einzigen Prozessschritt ersetzt.

Die in [1] vorgeschlagenen Lösungen beinhalten wesentlich mehr und kostenintensivere Prozeßschritte. Das in [2] beschriebene Verfahren eignet sich nur für strukturierte Wafer. Die Technik der Co-Diffusion kann bevorzugt nur mit kostenintensiven Aufdampftechniken realisiert werden, außerdem ist nach der Co-Diffusion kein weiterer Hochtemperaturschritt mehr möglich.

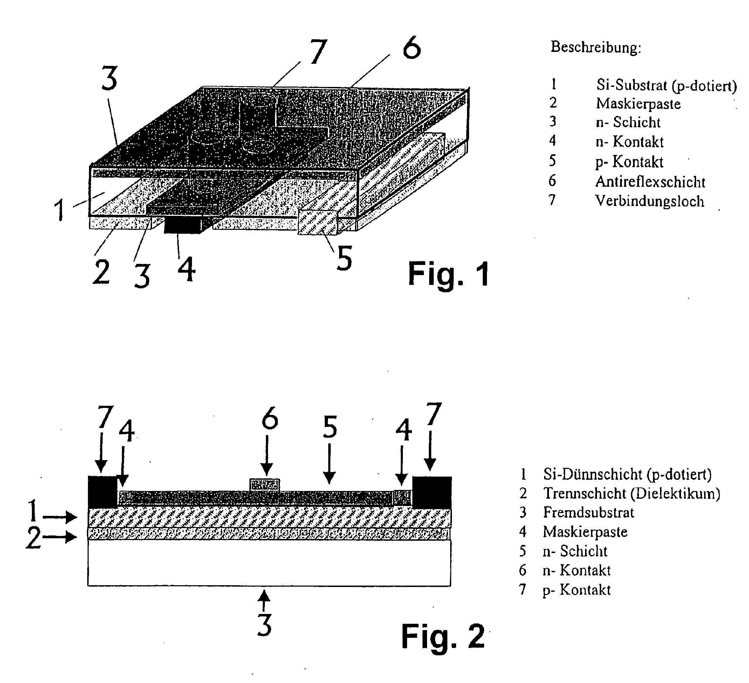

Die Erfindung wurde, wie im folgenden beschrieben, erprobt:
Die Diffusionsbarrierenpaste wurde auf 10 x 10 cm² großen Rückkontakt-Solarzellen angewendet. Die Wirkungsgrade dieser Zellen erreichten Werte von bis zu 15,8 % (unabhängig bestätigt vom EU Joint Research Center in Ispra, Italien). Die Solarzellenherstellung wurde erfolgreich sowohl an Cz-Si als auch an multikristallinem-Si erprobt. Im folgenden wird die Erfindung anhand zweier Ausführungsbeispiele näher erläutert. Es zeigen:
   **Fig.1:**
      Auf eine Halbleiterscheibe, bevorzugt kristallines Silizium (1), wird nach Ätz- und Reinigungsschritten lokal die Barrierenpaste aufgebracht (2). Anschließend wird die Siliziumscheibe einer n⁺-Diffusion ausgesetzt. Danach werden die n und p Kontakte (4 und 5) aufgebracht. In der Zeichnung ist speziell eine Zelle nach dem Emitter-Wrap-Through Verfahren dargestellt, d. h. die Frontseiten n-Schicht ist über kleine Löcher mit dem n-Kontakt auf der Rückseite der Zelle verbunden.
   **Fig. 2:**
      Eine auf Fremdsubstrat (3) aufgewachsene Dünnschichtzelle wird auf der Frontseite lokal mit der Maskierpaste (4) versehen und anschließend diffundiert. Die Kontakte (6 und 7) werden so auf die Zellvorderseite aufgebracht, daß n und p Kontakte durch die Maskierpaste voneinander getrennt sind.

## Patentansprüche

1. Verfahren zur Herstellung von Solarzellen aus kristallinem Silizium mit den Schritten
- des lokalen Aufbringens einer Maskierpaste (2, 4) mittels Drucktechnik auf wenigstens eine Seite eines Siliziumsubstrats (1) zwischen Bereichen, die für n-Kontakte (4, 6) und p-Kontakte (5, 7) vorgesehen sind,
- des anschließenden Trocknens der Maskierpaste (2, 4),
- der anschließenden Diffusion eines Dotierstoffes für einen Leitungstyp, der zu der Grunddotierung des Siliziumsubstrats (1) entgegengesetzt ist, und
- anschließend in einem der folgenden Schritte Aufbringen der Kontakte (4, 5, 6, 7) in den für den jeweiligen Kontakt (4, 5, 6, 7) vorgesehenen Bereichen.

2. Verfahren nach Anspruch 1, **dadurch gekennzeichnet, dass** das lokale Aufbringen der Maskierpaste (2, 4) auf beiden Seiten des Siliziumsubstrats (1) erfolgt.

3. Verfahren nach Anspruch 1 oder Anspruch 2, **dadurch gekennzeichnet, dass** durchgehende Löcher (7) in Flächenanteile eingebracht werden, die nicht mit Maskierpaste (2, 4) versehen sind.

4. Verfahren nach Anspruch 3, **dadurch gekennzeichnet, dass** die Löcher (7) mittels Laser eingebracht werden.

5. Verfahren nach Anspruch 3, **dadurch gekennzeichnet, dass** die Löcher (7) mechanisch eingebracht werden.

6. Verfahren nach einem der vorangehenden Ansprüche, **dadurch gekennzeichnet, dass** die Maskierpaste (2, 4) Oxide enthält.

7. Verfahren nach Anspruch 6, **dadurch gekennzeichnet, dass** die Oxide Übergangsmetalloxide sind.

8. Verfahren nach einem der vorangehenden Ansprüche, **dadurch gekennzeichnet, dass** das Siliziumsubstrat aus einer kristallinen Schicht (1) und einer Schicht (3) zusammengesetzt ist, die nicht aus Silizium besteht.

9. Verfahren nach einem der vorangehenden Ansprüche, bei dem eine Art der Dotierung auf der Rückseite der Solarzelle von dem Kontakt (4, 5, 6, 7), der die andere Art der Dotierung kontaktiert, durch die Maskierpaste (2, 4) getrennt ist.

## Claims

1. Method for producing solar cells from crystalline silicon, comprising the steps
- local application of a masking paste (2, 4) by means of a printing technique to at least one side of a silicon substrate (1) between regions which are intended for n-contacts (4, 6) and p-contacts (5, 7),
- subsequent drying of the masking paste (2, 4),
- subsequent diffusion of a dopant for a conductor type which is opposite to the basic doping of the silicon substrate (1), and
- subsequently, in one of the following steps, application of the contacts (4, 5, 6, 7) in the regions intended for the respective contact (4, 5, 6, 7).

2. Method according to Claim 1, **characterized in that** the local application of the masking paste (2, 4) is effected on both sides of the silicon substrate (1).

3. Method according to Claim 1 or Claim 2, **characterized in that** through-holes (7) are made in areas which are not provided with masking paste (2, 4).

4. Method according to Claim 3, **characterized in that** the holes (7) are made by means of a laser.

5. Method according to Claim 3, **characterized in that** the holes (7) are made mechanically.

6. Method according to any of the preceding Claims, **characterized in that** the masking paste (2, 4) contains oxides.

7. Method according to Claim 6, **characterized in that** the oxides are transition metal oxides.

8. Method according to any of the preceding Claims, **characterized in that** the silicon substrate is composed of a crystalline layer (1) and a layer (3) which does not consist of silicon.

9. Method according to any of the preceding Claims, in which one type of doping on the back of the solar cell is separated by the masking paste (2, 4) from the contact (4, 5, 6, 7) which contacts the other type of doping.

## Revendications

1. Procédé permettant de fabriquer des cellules solaires à partir de silicium cristallin, comprenant les étapes consistant à :
appliquer localement une pâte de masquage (2, 4) à l'aide d'une technique d'impression sur au moins une face d'un substrat de silicium (1) entre les zones qui sont prévues pour les contacts n (4, 6) et les contacts p (5, 7),
sécher ensuite la pâte de masquage (2, 4),
diffuser ensuite une substance dopante destinée à un type de conduction qui est opposé au dopage de base du substrat de silicium (1),
puis, dans l'une des étapes suivantes, appliquer les contacts (4, 5, 6, 7) dans les zones prévues pour le contact respectif (4, 5, 6, 7).

2. Procédé selon la revendication 1, **caractérisé en ce que** l'application locale de la pâte de masquage (2, 4) est réalisée sur les deux faces du substrat de silicium (1).

3. Procédé selon la revendication 1 ou 2, **caractérisé en ce que** des trous traversants (7) sont ménagés dans des sections de surface qui ne sont pas dotées de la pâte de masquage (2, 4).

4. Procédé selon la revendication 3, **caractérisé en ce que** les trous (7) sont réalisés à l'aide d'un laser.

5. Procédé selon la revendication 3, **caractérisé en ce que** les trous (7) sont réalisés par voie mécanique.

6. Procédé selon l'une quelconque des revendications précédentes, **caractérisé en ce que** la pâte de masquage (2, 4) contient de l'oxyde.

7. Procédé selon la revendication 6, **caractérisé en ce que** les oxydes sont des oxydes de métaux de transition.

8. Procédé selon l'une quelconque des revendications précédentes, **caractérisé en ce que** le substrat de silicium est constitué d'une couche cristalline (1) et d'une couche (3) qui n'est pas réalisée en silicium.

9. Procédé selon l'une quelconque des revendications précédentes, dans lequel un type de dopage sur la face arrière de la cellule solaire est séparé du contact (4, 5, 6, 7) contactant l'autre type de dopage, par la pâte de masquage (2, 4).
